# EUROPÄISCHE PATENTANMELDUNG

(11) **EP 2 824 597 A1**
(43) Veröffentlichungstag der Anmeldung: **14.01.2015**
(21) Anmeldenummer: 14169791.2
(22) Anmeldetag: 26.05.2014
(51) Int. Cl.: G06F 17/50

(54) **Verfahren zum Überprüfen von unterschiedlichen Modellen einer logischen Schaltung**

(30) Priorität: 09.07.2013 DE 102013213423
(71) Anmelder: Siemens AG Österreich, 1210 Wien (AT)
(72) Erfinder: Eppensteiner, Friedrich, 3620 Spitz (AT); Ghameshlu, Majid, 1110 Wien (AT); Matschnig, Martin, 3430 Tulln (AT); Taucher, Herbert, 2340 Mödling (AT)
(74) Vertreter: Maier, Daniel Oliver

(57) **Zusammenfassung**

Die Erfindung betrifft ein Verfahren zum automatisierten Anpassen von Parametereinstellungen (PS) bei einem Schaltungsmodell (SL) für eine logische, elektronische Schaltung, insbesondere eine anwendungsspezifische, integrierte Schaltung. Das Schaltungsmodell (SL) wird dabei mit Hilfe einer Systemmodellierungssprache bzw. mittel Electronic System Level Design erstellt und es wird durch Vorgabe von Parameterwerten ein funktionelles Verhalten des Schaltungsmodells (SL) definiert, wobei zuerst Startparameterwerte für das Schaltungsmodell (SL) vorgegeben und dann zu überprüfende Funktionseinheiten des Schaltungsmodells (SL) festgelegt werden (1). Danach werden die festgelegten Funktionseinheiten des Schaltungsmodells (SL) in einer vorgegebenen Simulationsumgebung (S) parallel zu entsprechenden Funktionsblöcken eines Hardwarebeschreibungsmodells (HB) mit Zufallsdaten (ZD) stimuliert (2) und das funktionelle Verhalten der Funktionseinheiten des Schaltungsmodells (SL) mit dem Verhalten der Funktionsblöcke des Hardwarebeschreibungsmodells (HB) verglichen sowie Abweichungen ermittelt (3). Dann wird über eine Optimierungsanwendung (OA) die Parametereinstellung (PS) der jeweiligen Funktionseinheiten des Schaltungsmodells (SL) auf Basis der ermittelten Abweichungen derart geändert, dass für die Abweichungen ein Minimum erzielt wird (4, 5). Die Anpassung der Parametereinstellung (PS) an das einer realen Implementierung der Schaltung entsprechende Hardwarebeschreibungsmodell (HB) erfolgt damit auf einfache Weise voll automatisiert und es bedarf keiner genauen Detailkenntnisse der technischen Realisierung (z.B. Hardware- und/oder Software-Einheiten) der logischen Schaltung.

## Beschreibung

### Technisches Gebiet

Die vorliegende Erfindung betrifft allgemein das Gebiet der der logischen, elektronischen Schaltungen, insbesondere der so genannten anwendungsspezifischen, integrierten Schaltungen (ASICs) und/oder der so genannten Field Programmable Gate Arrays (FPGAs). Im Speziellen bezieht sich die vorliegende Erfindung auf ein Verfahren zum automatisierten Anpassen von Parametereinstellungen bei einem Schaltungsmodell einer logischen Schaltung, welches mit Hilfe einer Systemmodellierungssprache erstellt worden ist. Dabei wird das funktionelle Verhalten des Schaltungsmodells und der darauf basierenden logischen Schaltung durch eine Vorgabe von Parameterwerten definiert.

### Stand der Technik

Logische Schaltungen wie z.B. ASICs oder FPGAs bilden heutzutage in der Computertechnik eine Grundlage für jegliche Elektronik. Derartige Schaltungen bestehen üblicherweise aus miteinander verdrahteten elektronischen Bauelementen, welche auf einem einzelnen Substrat (z.B. Halbleitersubstrat) untergebracht sind. Bei einer integrierten Schaltung sind die Anzahl an verschiedenen Bauelementen bzw. Funktionsblöcken oder Gatter sowie die verbindenden Leiterzüge auf oder in einem einkristallinen Substrat untergebracht. Damit können umfangreiche Funktionalitäten und Anwendungen auf einem kleinen Raum zur Verfügung gestellt werden. Durch den Fortschritt der technischen Entwicklung ist es mittlerweile möglich, auch große komplexe logische Schaltungen auf einem Halbleiter-Chip unterzubringen.

Bei der Entwicklung bzw. dem Design von derartigen logischen Schaltungen werden häufig rechnergestützte Hilfsmittel wie z.B. Systemmodellierungssprachen eingesetzt. Mit Hilfe einer Systemmodellierungs- oder High-Level-Modellierungssprache (z.B. SystemC, SystemVerilog, etc.) werden beispielsweise virtuelle Prototypen bzw. Schaltungsmodelle von logischen Schaltungen mit einem relativ hohen Abstraktionsgrad entworfen und erstellt. Dabei wird das Schaltungsmodell der logischen Schaltung z.B. anhand von Funktionen, funktionellen Verhalten, Algorithmen, etc. beschrieben und daraus dann die entsprechenden Funktionseinheiten bzw. Hardware-Funktionsblöcke für die logische Schaltung abgeleitet. Derartige Schaltungsmodelle werden beim Design logischer Schaltungen auch als High-Level-Modelle bezeichnet.

Dabei können Schaltungsmodelle mit höherem Abstraktionsgrad bzw. High-Level-Modelle z.B. leichter und rascher simuliert werden als sehr genaue Schaltungsmodelle mit eine geringeren Abstraktionsgrad. Mit Hilfe eines Schaltungsmodells mit höherem Abstraktionsgrad wie einem High-Level-Modell kann damit leichter und rascher eine Simulation zur Überprüfung und Verifikation von geforderten Funktionalitäten durchgeführt werden. High-Level-Schaltungsmodelle bilden auch eine Basis für Architekturvergleich von Schaltungen und für Analysen in einer frühen Konzeptions- und Entwicklungsphase von logischen Schaltungen. Allerdings werden High-Level-Schaltungsmodelle anfangs ohne festgelegtes funktionelles Verhalten kreiert. Das funktionelle Verhalten des Schaltungsmodells bzw. seiner Einzelkomponenten/Funktionseinheiten wird üblicherweise durch Vorgabe von entsprechenden Parametern definiert. Es können dann mit einem Schaltungsmodell, dessen funktionelles Verhalten durch Parameterwerte ungefähr festgelegt worden ist, beispielsweise kritische Algorithmen, etc. für die endgültige logische Schaltung bzw. für die reale Implementierung der Schaltung entwickelt und getestet werden.

Im weiteren Verlauf des Designs und der folgenden Implementierung einer logischen Schaltung wird der Abstraktionsgrad des Schaltungsmodells reduziert bzw. es werden auf Basis eines High-Level-Schaltungsmodells weitere Schaltungsmodelle mit niedrigern Abstraktionsgraden abgeleitet - wie z.B. ein Hardwarebeschreibungsmodell der logischen Schaltung. Es ist aber auch möglich, ein Schaltungsmodell mit niedrigerem Abstraktionsgrad direkt mit Hilfe einer so genannten Hardwarebeschreibungssprache (z.B. VHDL, Verilog, etc.) zu kreieren. Ein direkt kreiertes Hardwarebeschreibungsmodell kann beispielsweise für Testzwecke verwendet werden. Vom Hardwarebeschreibungsmodell wird üblicherweise ein endgültiges Design der logischen Schaltung dargestellt, welches dann auf einem Halbleitersubstrat realisiert wird. Das Hardwarebeschreibungsmodell mit seinen Funktionsblöcken gibt dabei eine genaue Anleitung für die reale Implementierung der logischen Schaltung vor.

Für die Implementierung eines High-Level-Schaltungsmodells als logische, elektronische Schaltung bzw. das Erstellen eines Hardwarebeschreibungsmodells sind dabei Modelle aller Einzelkomponenten bzw. Funktionseinheiten notwendig. Speziell bei Verwendung von existenten Funktionseinheiten, welche z.B. bereits als realisierte Funktionsblöcke oder Schaltungseinheiten bereits existieren, muss in einem Schaltungsmodell auf eine hinreichend gute Korrelation mit einem realen funktionellen Verhalten dieser Funktionseinheiten und des gesamten Schaltungsmodells geachtet werden, um Fehler bei der realen Implementierung der Schaltung zu vermeiden. Deswegen ist eine entsprechend genaue Vorgabe von Parameterwerten, welche das funktionelle Verhalten des (High-Level)-Schaltungsmodells z.B. in der Entwicklungs- und Testphase festlegen, für die Qualität der Korrelation des Schaltungsmodells mit einer realen Implementierung bzw. mit einem entsprechenden Hardwarebeschreibungsmodell wichtig für die Entwicklung und Analyse einer logischen Schaltung, damit diese dann das gewünschte funktionelle Verhalten im realen Einsatz aufweist, oder um ein entsprechend aussagekräftiges Analyseergebnis über z.B. die Implementierung/Architektur einer realen logischen Schaltung zu erhalten.

Eine Möglichkeit, um die Qualität der Korrelation des Schaltungsmodells mit einer realen Implementierung bzw. mit einem entsprechenden Hardwarebeschreibungsmodell zu bestimmen, ist eine Durchführung von umfangreichen und detaillierten Vergleichssimulationen. Dazu werden die Parameterwerte, durch welche das funktionelle Verhalten des High-Level-Schaltungsmodells definiert wird, manuell vorgegeben. Die Simulationsergebnisse der Schaltungsmodelle werden miteinander verglichen und dann die Parameterwerte iterativ manuell an die zu analysierende implementierte Schaltung bzw. das Hardwarebeschreibungsmodell, welches eine exakte Beschreibung der Schaltungsimplementierung darstellt, angepasst. Dieser Ansatz weist allerdings den Nachteil auf, dass einerseits für detaillierten Vergleichssimulationen große Rechnerressourcen bzw. ein hoher Hardware-Aufwand notwendig sind. Andererseits ist es bei dieser Vorgehensweise von Nachteil, dass die Anpassung der Parameterwerte des Schaltungsmodells sehr aufwendig und zeitintensiv ist und gegebenenfalls z.B. vom Entwickler manuell in mehreren Schritten durchgeführt werden muss. Weiterhin ist die Qualität der Korrelation des Schaltungsmodells mit der realen Implementierung bzw. mit dem Hardwarebeschreibungsmodell durch die manuelle und schrittweise Anpassung der Parameter sehr eingeschränkt.

### Darstellung der Erfindung

Der Erfindung liegt daher die Aufgabe zugrunde, ein Verfahren anzugeben, durch welches auf einfache und automatisierte Weise eine rasche Anpassung von Parametereingabe eines Schaltungsmodells einer logischen Schaltung - d.h. von Parametern eines High-Level-Modells - an ein Verhalten einer realen Schaltungsimplementierung mit einer hohen Qualität ermöglicht wird.

Diese Aufgabe wird durch ein Verfahren der eingangs genannten Art mit den Merkmalen gemäß dem unabhängigen Patentanspruch gelöst. Vorteilhafte Ausführungsformen der vorliegenden Erfindung sind in den abhängigen Ansprüchen beschrieben. Erfindungsgemäß erfolgt die Lösung der Aufgabe mit einem Verfahren der eingangs erwähnten Art, bei welchem für ein Schaltungsmodell Startparameterwerte vorgegeben werden, um ein funktionelles Startverhalten zu definieren, sowie zu überprüfende Funktionseinheiten festzulegen. Dann werden diese Funktionseinheiten des Schaltungsmodells in einer vorgegebenen Simulationsumgebung parallel zu entsprechenden Funktionsblöcken eines dem Schaltungsmodell entsprechenden Hardwarebeschreibungsmodells der logischen Schaltung mit Zufallsdaten stimuliert. Dann wird das funktionelle Verhalten der jeweiligen Funktionseinheiten des Schaltungsmodells mit einem Verhalten der entsprechenden Funktionsblöcke des Hardwarebeschreibungsmodells verglichen und Abweichungen ermittelt. Auf Basis dieser Abweichungen werden über eine Optimierungsanwendung die Parametereinstellungen der jeweiligen Funktionseinheiten des Schaltungsmodells derart geändert, dass für die Abweichungen ein Minimum erzielt wird.

Der Hauptaspekt der erfindungsgemäß vorgeschlagenen Lösung besteht darin, dass die Anpassung der Parametereinstellung des Schaltungsmodells bzw. seiner Funktionseinheiten an eine reale Implementierung der logischen Schaltung bzw. an eine der realen Implementierung entsprechenden Hardwarebeschreibung ohne großen Aufwand automatisiert - d.h. ohne manuellen Eingriff - durchgeführt wird. Diese Anpassung kann insbesondere ohne großen zeitlichen und/oder ressourcenmäßigen Aufwand erzielt werden. Weiterhin sind für die Anpassung der Parameter keine detaillierten Kenntnisse der technischen Realisierung der logischen Schaltung bzw. der Hardwarebeschreibung notwendig, um ein Schaltungsmodell mit einer hohen Qualität in Korrelation mit der realen Implementierung bzw. dem Hardwarebeschreibungsmodell zu erhalten. Es können daher z.B. aussagekräftige Analysen mit dem Schaltungsmodell, welches einen hohen Abstraktionsgrad aufweist und die logische Schaltung funktionell beschreibt, durchgeführt werden.

Dabei ist es von Vorteil, wenn von der Optimierungsanwendung aus den ermittelten Abweichungen neue Parameterwerte für das

Schaltungsmodell abgeleitet und dem Schaltungsmodell vorgegeben werden. Mit diesen neuen verbesserten Parameterwerten wird dann ein neuer Vergleich des funktionellen Verhaltens der jeweiligen Funktionseinheiten des Schaltungsmodells mit dem Verhalten der entsprechenden Funktionsblöcke des Hardwarebeschreibungsmodells durchgeführt. Auf diese Weise können die Parametereinstellungen des Schaltungsmodells automatisiert stufenweise angepasst und damit das funktionelle Verhalten des Schaltungsmodells iterativ verbessert und an das Verhalten der realen Implementierung bzw. des Hardwarebeschreibungsmodells angeglichen werden.

Eine Änderung der neuen Parameterwerte bzw. die Anpassung der Parametereinstellungen des Schaltungsmodells kann dabei in vorteilhafter Weise stufenweise auf Basis der jeweils ermittelten Abweichungen durchgeführt werden. Dafür können beispielsweise Messintervalle mit verschiedener Granularität bzw. mit unterschiedlicher Intervalllänge, -unterteilung und - dauer definiert werden. Diese Messintervalle werden dann der Reihe nach - z.B. zuerst Messintervalle mit einer groben Granularität und dann Messintervalle mit einer feinen Granularität - für die Anpassung der Parametereinstellungen des Schaltungsmodells bzw. für die Parametervorgaben für die Definition des funktionellen Verhaltens des Schaltungsmodells herangezogen.

Das funktionelle Verhalten, welches durch die Parametereinstellungen für das Schaltungsmodell definiert wird, kann dabei entweder ein zeitabhängiges Verhalten oder ein leistungsabhängiges Verhalten sein, für welches über die Anpassung der Parametereinstellung des Schaltungsmodells eine hinreichend gute Korrelation mit einem realen Zeit- und/oder Leistungsverhalten einer logischen Schaltung ermittelt wird. Durch Überprüfung und Vergleich des zeitabhängigen bzw. leistungsabhängigen Verhaltens von Funktionseinheiten des Schaltungsmodells mit einem Zeit- bzw. Leistungsverhalten von entsprechenden Funktionsblöcken in der Hardwarebeschreibung bzw. in einer realen Implementierung können sehr einfach die entsprechenden Parametereinstellung für das Schaltungsmodell automatisiert angepasst und verbessert werden. Das Schaltungsmodell wird damit beispielsweise in Bezug auf Funktion, zeitliche und/oder leistungsabhängige Charakterisierung möglichst genau an die reale Implementierung angepasst. Damit können sehr einfach dann z.B. zeit- und/oder leistungskritische Algorithmen und Vorgänge für eine endgültige logische Schaltung mit dem Schaltungsmodell aussagekräftig analysiert, verbessert oder weiterentwickelt werden.

Idealer Weise wird das Schaltungsmodell der logischen Schaltung mit dem so genannten Electronic System Level Design oder ESL-Design erstellt. Beim ESL-Design wird ein Schaltungsmodell mit hohen Abstraktionsgrad in einer high-level Programmiersprache wie z.B. SystemC, SystemVerilog, etc. entworfen. Vom Schaltungsmodell wird dabei die logische Schaltung z.B. anhand von Funktionen, Algorithmen, Verhalten, etc. beschrieben. Mit ESL-Design kann dabei sehr einfach ein Schaltungsmodell kreiert werden, in welchem vorerst kein funktionelles Verhalten z.B. im Bezug auf Zeit und/oder Leistung vorgesehen ist. Das funktionelle Verhalten wird dann durch die Parametereinstellungen festgelegt. Damit kann ein derartiges Schaltungsmodell sehr einfach und ohne Re-Design an ein gewünschtes funktionelles Verhalten angepasst werden. Weiterhin kann aus einem mittels ESL-Design kreierten Schaltungsmodell sehr rasch und einfach - z.B. in einem automatisierten Design-Prozess - eine Implementierungsvorschrift für eine zu realisierende logische Schaltung abgeleitet werden.

Es ist auch günstig, wenn für die Erstellung des Hardwarebeschreibungsmodells der logischen Schaltung bzw. für die reale Implementierung eine Hardwarebeschreibungssprache wie z.B. VHDL, Verilog oder Simulink, etc. verwendet wird. Von einem Hardwarebeschreibungsmodell wird ein endgültiges Design der logischen Schaltung dargestellt - d.h. es wird die logische Schaltung bzw. Hardware derart beschrieben, wie diese auf einem Halbleitersubstrat realisiert wird. Damit weist das Hardwarebeschreibungsmodell üblicherweise das reale funktionelle Verhalten der logischen Schaltung - z.B. Zeit- und/oder Leistungsverhalten - auf. Durch die Verwendung des Hardwarebeschreibungsmodells in einer Hardwarebeschreibungssprache wie z.B. VHDL, Verilog oder Simulink, etc. zum Anpassen der Parametereinstellung des Schaltungsmodells kann die Parametereinstellung sehr rasch und ohne großen Aufwand automatisch an reale Gegebenheiten angepasst werden.

### Kurzbeschreibung der Zeichnung

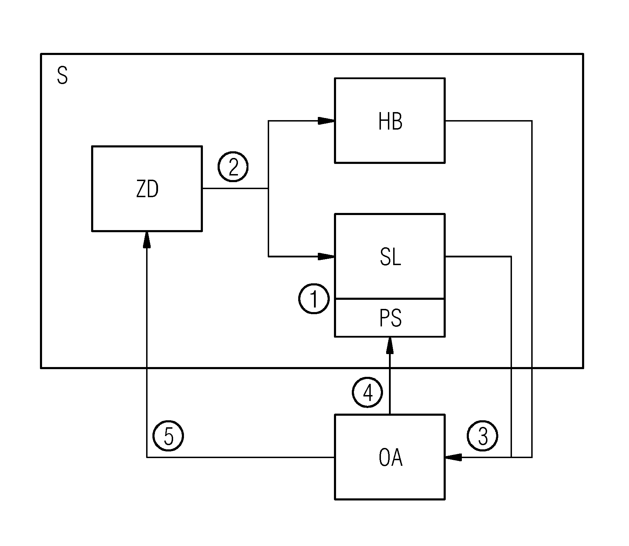

Die Erfindung wird nachfolgend in beispielhafter Weise anhand der beigefügten Figur erläutert. Es zeigt Figur 1 schematisch einen beispielhaften Ablauf des erfindungsgemäßen Verfahrens zum automatisierten Anpassen von Parametereinstellungen eines Schaltungsmodells einer logischen Schaltung.

### Ausführung der Erfindung

Figur 1 zeigt in schematischer Weise eine beispielhafte Simulationsumgebung S, welche für eine parallele Stimulation von einem Schaltungsmodell SL und einem Hardwarebeschreibungsmodell HB einer logischen Schaltung mit Zufallsdaten ZD eingerichtet ist. In der Simulationsumgebung S soll ein funktionelles Verhalten des Schaltungsmodells SL mit einer realen Implementierung, welche durch das Hardwarebeschreibungsmodell HB repräsentiert wird, anhand von einer Vergleichs- oder Referenzsimulation überprüft werden.

Das Hardwarebeschreibungsmodell HB wurde dazu in einer so genannten Hardwarebeschreibungssprache wie z.B. VHDL, Verilog, Simulink, etc. implementiert. Vom Hardwarebeschreibungsmodell HB wird dabei ein endgültiges Design der logischen Schaltung dargestellt und es wird die logische Schaltung bzw. deren Funktionsblöcke derart beschrieben, wie diese auf einem Halbleitersubstrat realisiert werden. D.h. das Hardwarebeschreibungsmodell HB weist üblicherweise ein reales funktionelles Verhalten der logischen Schaltung auf, wie die für reale Einsätze implementierte logische Schaltung.

Das Schaltungsmodell SL ist nach dem so genannten Electronic System Level oder ESL-Design mit Hilfe einer Systemmodellierungs- oder High-Level-Modellierungssprache wie z.B. SystemC, SystemVerilog, etc. erstellt worden. Dabei wird vom Schaltungsmodell SL die logische Schaltung mit einem hohen Abstraktionsgrad beispielsweise anhand von Funktionen, Algorithmen, Verhalten, etc. beschrieben, durch welche die Funktionseinheiten des Schaltungsmodells dargestellt werden. In der Modellarchitektur wird dann mit einer Parametereinstellung PS ein Set von Parameterwerten vorgegeben, durch welches ein funktionelles Verhalten - wie z.B. ein zeitabhängiges und/oder leistungsabhängiges Verhalten - des Schaltungsmodells SL beispielsweise in Abhängigkeit von einer Historie, einem aktuellen Zustand und/oder einem aktuellen Input, etc. definiert werden kann. Dabei ist es wichtig, dass die Funktionseinheiten des Schaltungsmodells SL, insbesondere wenn diese bereits existierenden Funktionsblöcken bzw. Komponenten von logischen Schaltungen, trotz des hohen Abstraktionsgrades des Schaltungsmodells SL mit diesen existierenden Funktionsblöcken hinreichend gut in ihrem funktionellen Verhalten korrelieren.

Für das erfindungsgemäße Verfahren zum automatisierten Anpassen von der Parametereinstellung PS beim Schaltungsmodell SL einer logischen Schaltung werden in einem ersten Verfahrensschritt 1 Startparameterwerte als eine erste Parametereinstellung PS vorgegeben, um ein gewünschtes bzw. vorgegebenes funktionelles Verhalten zu erreichen. Weiterhin werden dann zu überprüfende Funktionseinheiten des Schaltungsmodells SL festgelegt, wobei diese Funktionseinheiten beispielsweise weitgehend (bereits existierenden) Funktionsblöcken des Hardwarebeschreibungsmodells HB entsprechen.

In einem zweiten Verfahrensschritt 2 werden dann die festgelegten Funktionseinheiten des Schaltungsmodells SL in der vorgegebenen Simulationsumgebung S parallel zu den entsprechenden Funktionsblöcken des Hardwarebeschreibungsmodells HB mit den Zufallsdaten ZD stimuliert. Dabei wird parallel das funktionelle Verhalten der Funktionseinheiten des Schaltungsmodells SL sowie ein Verhalten der entsprechenden Funktionsblöcke des Hardwarebeschreibungsmodells HB erfasst. In einem dritten Verfahrensschritt 3 werden dann das funktionelle Verhalten der Funktionseinheiten des Schaltungsmodells SL und das Verhalten der entsprechenden Funktionsblöcke des Hardwarebeschreibungsmodells HB und damit der realen Implementierung verglichen. Daraus werden dann Abweichungen zwischen dem funktionellen Verhalten des Schaltungsmodells SL bzw. seiner Funktionseinheiten vom Verhalten des Hardwarebeschreibungsmodells HB bzw. dessen Funktionsblöcken ermittelt.

In einem vierten Verfahrensschritt 4 wird dann von einer Optimierungsanwendung OA eine neue Parametereinstellung PS für das Schaltungsmodells SL bzw. für die jeweiligen Funktionseinheiten derart ermittelt, dass für die Abweichungen ein Minimum erzielt wird. Dazu werden von der Optimierungsanwendung OA aus den Abweichungen neue Parameterwerte für die neue, verbesserte Parametereinstellung PS abgeleitet und dann als neues Set an Parameterwerten dem Schaltungsmodell SL für einen weiteren Durchlauf der Vergleichssimulation bzw. des erfindungsgemäßen Verfahrens vorgegeben. In einem fünften Verfahrensschritt 5 kann dann die Vergleichssimulation für die Funktionseinheiten des Schaltungsmodells SL mit den entsprechenden Funktionsblöcken des Hardwarebeschreibungsmodells HB durch Stimulation mit Zufallsdaten ZD erneut angestoßen werden. Über die Optimierungsanwendung OA kann dann die Verbesserung der Parametereinstellung PS solange ausgesteuert werden, bis ein Minimum für die Abweichungen über hinreichend viele Stimulierungen durch Zufallsdaten erreicht worden ist.

Dabei kann die Ermittlung einer Parametereinstellung PS, durch welche dann das Schaltungsmodell SL eine mit dem Hardwarebeschreibungsmodell HB bzw. der realen Implementierung hinreichende Qualität der Korrelation aufweist bzw. durch welche dann die reale Implementierung hinreichend charakterisiert wird, beispielsweise stufenweise durchgeführt werden. Dazu werden Messintervalle mit verschiedener Granularität definiert, welche dann der Reihe nach - z.B. zuerst die Messintervalle mit grober Granularität und dann jene mit feiner Granularität - für die Anpassung der Parametereinstellung PS herangezogen werden.

Mit dem erfindungsgemäßen Verfahren können auf einfache und automatisierte Weise Parametereinstellungen für ein Schaltungsmodell SL einer logischen Schaltung mit hohen Abstraktionsgrad gefunden werden, welche die reale Implementierung der logischen Schaltung - wie diese z.B. im entsprechenden Hardwarebeschreibungsmodell HB hinterlegt ist - charakterisieren. Das Schaltungsmodell SL weist dann mit der mit Hilfe des erfinderischen Verfahrens ermittelten Parametereinstellung PS eine sehr gute Qualität der Korrelation mit der realen Implementierung auf und kann damit für aussagekräftige Analyseergebnisse z.B. im Bezug auf funktionelles Verhalten (z.B. Zeit- und/oder Leistungsverhalten) in der Entwicklung und Überprüfung von logischen Schaltungen eingesetzt werden.

## Patentansprüche

1. Verfahren zum automatisierten Anpassen von Parametereinstellungen (PS) bei einem Schaltungsmodell (SL) einer logischen Schaltung, welches mit Hilfe einer Systemmodellierungssprache erstellt worden ist, und bei welchem durch eine Vorgabe von Parameterwerten ein funktionelles Verhalten definiert wird, **dadurch gekennzeichnet, dass** für das Schaltungsmodell (SL) Startparameterwerte vorgegeben werden (1), dass dann zu überprüfende Funktionseinheiten des Schaltungsmodells (SL) festgelegt werden (1), dass diese Funktionseinheiten in einer vorgegebenen Simulationsumgebung (S) parallel zu entsprechenden Funktionsblöcken eines Hardwarebeschreibungsmodells (HB) der logischen Schaltung mit Zufallsdaten (ZD) stimuliert werden (2), dass dann das funktionelle Verhalten der jeweiligen Funktionseinheiten des Schaltungsmodells (SL) mit einem Verhalten der entsprechenden Funktionsblöcke des Hardwaresimulationsmodells (HB) verglichen wird und Abweichungen ermittelt werden (3), und dass dann über eine Optimierungsanwendung (OA) die Parametereinstellungen der jeweiligen Funktionseinheiten des Schaltungsmodells (SL) derart geändert werden, dass für die Abweichungen ein Minimum erzielt wird (4, 5).

2. Verfahren nach Anspruch 1, **dadurch gekennzeichnet, dass** von der Optimierungsanwendung (OA) aus den ermittelten Abweichungen neue Parameterwerte für das Schaltungsmodell (SL) abgeleitet und dem Schaltungsmodell (SL) vorgegeben werden (4), und dass dann ein neuer Vergleich des funktionellen Verhaltens der jeweiligen Funktionseinheiten des Schaltungsmodells (SL) mit dem Verhalten der entsprechenden Funktionsblöcke des Hardwarebeschreibungsmodells (HB) durchgeführt wird (5).

3. Verfahren nach den Ansprüchen 1 bis 2, **dadurch gekennzeichnet, dass** eine Änderung neuer Parameterwerte auf Basis der ermittelten Abweichungen stufenweise durchgeführt wird (4, 5).

4. Verfahren nach einem der Ansprüche 1 bis 3, **dadurch gekennzeichnet, dass** als funktionelles Verhalten des Schaltungsmodells (SL) ein zeitabhängiges Verhalten ermittelt und überprüft wird.

5. Verfahren nach einem der Ansprüche 1 bis 3, **dadurch gekennzeichnet, dass** als funktionelles Verhalten des Schaltungsmodells (SL) ein leistungsabhängiges Verhalten ermittelt und überprüft wird.

6. Verfahren nach einem der Ansprüche 1 bis 5, **dadurch gekennzeichnet, dass** das Schaltungsmodell (SL) der logischen Schaltung mit dem so genannten Electronic System Level Design oder ESL-Design erstellt wird.

7. Verfahren nach einem der Ansprüche 1 bis 6, **dadurch gekennzeichnet, dass** das Hardwarebeschreibungsmodell (HB) der logischen Schaltung mit einer Hardwarebeschreibungssprache wie beispielsweise VHDL, Verilog oder Simulink erstellt wird.
